# EUROPÄISCHE PATENTSCHRIFT

(11) **EP 3 295 190 B1**
(45) Veröffentlichungstag und Bekanntmachung des Hinweises auf die Patenterteilung: **10.07.2019**
(21) Anmeldenummer: 16722632.3
(22) Anmeldetag: 09.05.2016
(51) Int. Cl.: G01R 31/28

(54) **ANORDNUNG VON LEITBAHNEN, VORRICHTUNG UND VERFAHREN ZUR FEHLERBESTIMMUNG EINER HALBLEITERSCHALTUNG**
ASSEMBLY OF CONDUCTING TRACKS, DEVICE, AND METHOD FOR THE FAULT DETECTION OF A SEMICONDUCTOR CIRCUIT
AGENCEMENT DE TRACÉS CONDUCTEURS ET DISPOSITIF ET PROCÉDÉ DE DÉTECTION D'ANOMALIES D'UN CIRCUIT À SEMI-CONDUCTEURS

(30) Priorität: 11.05.2015 DE 102015107301
(43) Veröffentlichungstag der Anmeldung: 21.03.2018
(73) Patentinhaber: Robert Bosch GmbH, 70442 Stuttgart (DE)
(72) Erfinder: DIETZ, Franz, 72820 Willmandingen (DE); TENG, Lichao, 72764 Reutlingen (DE); OST, Markus, 70372 Stuttgart (DE)
(86) Internationale Anmeldenummer: PCT/EP2016/060288
(87) Internationale Veröffentlichungsnummer: WO 2016/180758

(56) Entgegenhaltungen:
- US-A1- 2002 017 906
- US-A1- 2009 012 747
- US-A1- 2009 033 351
- US-A1- 2013 038 334
- MITCHELL M A ET AL: "ISSUES WITH CONTACT DEFECT TEST STRUCTURES", PROCEEDINGS OF THE INTERNATIONAL CONFERENCE ON MICROELECTRONIC TEST STRUCTURES (ICMTS). SAN DIEGO, MAR. 16 - 19, 1992; [PROCEEDINGS OF THE INTERNATIONAL CONFERENCE ON MICROELECTRONIC TEST STRUCTURES (ICMTS)], NEW YORK, IEEE, US, Bd. -, 16. März 1992 (1992-03-16), Seiten 53-56, XP000340695, DOI: 10.1109/ICMTS.1992.185936 ISBN: 978-0-7803-0535-9

## Beschreibung

### Stand der Technik

Die Erfindung betrifft eine Anordnung von Leitbahnen, eine Vorrichtung und ein Verfahren zur Fehlerbestimmung einer Halbleiterschaltung.

Integrierte Schaltungen beinhalten eine Vielzahl von hochintegrierten Schaltungselementen, die über eine komplexe Metallisierung verbunden sind, beispielsweise Transitoren, Widerstände oder Kapazitäten. Während des Betriebs der integrierten Schaltungen fließen Ströme über die Metallisierung, wobei aufgrund der geringen Leitungsquerschnitte bzw. innerhalb von Verbindungsstellen der Metallebenen sehr hohe Stromdichten auftreten können, typischerweise im Bereich bis 1 MA/cm². Dabei kommt es zu einem Fehlermechanismus, der sogenannten Elektromigration. Elektronen kollidieren mit Atomen der Leitbahn, wobei ein Impulsübertrag erfolgt, der zu einer Verschiebung bzw. Diffusion des Metallatoms in Richtung des Elektronenflusses führt. Kommt es hierbei zu einer Massenflussdivergenz, entstehen Hohlräume in der Leitbahn, d. h. es bewegen sich an bestimmten Stellen der Metallisierung mehr Metallatome weg als nachgeliefert werden, z. B. an Korngrenzen oder Vias, die aus einem anderen Material wie beispielsweise Wolfram bestehen. Nachteilig ist hierbei, dass die Leitbahn abreißt, d. h. die Leitbahn ist unterbrochen und die elektrische Funktionalität des ASICs ist nicht mehr gegeben. Steigende Temperatur erhöht ebenfalls den Effekt der Elektromigration. Der Effekt ist außerdem signifikant abhängig von der Eigenerwärmung der Leitbahn, dem Signalverlauf der Belastung, wobei AC-Ströme weniger Degradation erzeugen, dem verwendeten Metall z. B. Al, W, Cu, Ti, etc. und dessen mechanischen Eigenschaften, den Prozessierungsparametern der Metallsierung, inklusive Prozessfehler und dem Layout, beispielsweise Länge und Breite der Leitbahn.

Zur Bestimmung von Fehlermechnismen ist es bekannt, die maximale Belastbarkeit der Leitbahnen, VIAs und Kontakte zu evaluieren. Verfahren und Teststrukturen hierzu sind standardisiert, z. B. JEDEC-Standards JESD61, JESD63, JESD87. Des Weiteren ist die Simulation des Effekts der Elektromigration mit der Finiten-Elemente-Methode bekannt. Außerdem werden beschleunigte Testverfahren und Zuverlässigkeitstests zu den Bedingungen der realen Applikation korreliert, beispielsweise beschrieben in "Simulation of Electromigration Test Structures with and without Extrusion Monitors", V. Hein, ICSE 2006.

Die Schrift DE 10 2008 000 218 A1 beschreibt eine verbesserte Teststruktur mit der Zielsetzung die entsprechenden Testzeiten in Schnelltests zu verringern.

Bekannt ist ebenfalls, dass die Auslegung der Leitbahnbreiten auf Annahmen der tatsächlichen Feldbelastung und Belastbarkeit der Metallisierung basiert. Ist die tatsächliche Belastung höher oder die Metallisierung fehlerhaft, besteht die Gefahr von Ausfällen trotz bestandener Qualitätsprüfung und Funktionsprüfung.

Das Dokument US 8890556 B2 offenbart, dass die Elektromigration in der Applikation permanent überwacht wird und beschreibt entsprechende im ASIC ablaufende Messzyklen.

Weitere Teststrukturen sind aus dem Dokument 'ISSUES WITH CONTACT DEFECT TEST STRUCTURES', Mitchell et al, PROCEEDINGS OF THE INTERNATIONAL CONFERENCE ON MICROELECTRONIC TEST STRUCTURES (ICMTS). SAN DIEGO, MAR. 16- 19, 1992, IEEE, S. 53-56, XP000340695, und aus US2002/017906, US2009/012747, US2013/038334, und US2009/033351 bekannt.

Bekannte Strukturen aus der Standarderprobung basieren auf Langzeitmessungen an einzelnen Leitbahnen, und erfassen die zum Zeitpunkt der Erprobung kritischste Dimension der Leitbahn, bei der die stärkste Elektromigration vorliegt, um so die maximale Belastbarkeit festzulegen. Zielsetzung der Qualifikation ist dabei keine Relativmessung, da entsprechende Messgeräte absolute Größen für den Widerstand angeben können und für die Spezifikation der maximalen Belastbarkeit absolute Größen angegeben werden müssen.

Die Qualifikation prüft nur eine eingeschränkte Menge an Material ab. Dabei soll die kritischste im Feld auftretende Belastung, d. h. maximaler Strom auf instabilste Leitbahn bei höchster Temperatur, abgesichert werden. Das führt zu einer Überdimensionierung, aber unerwartete niedrige Belastbarkeiten, z.B. durch Prozessschwankungen, oder ungeplante Überlastungen, z. B. permanenter Betrieb an der Belastungsgrenze, können nicht kosteneffizient abgedeckt werden.

Die Elektromigration ist stark abhängig von der Leitbahnbreite und weist den "Bamboo-Effekt" auf. Dabei ist die Elektromigrationsstabilität von sehr dünnen Leitbahnen sehr hoch, da Korngrenzen statistisch sehr oft senkrecht zur Leitbahn liegen, aber eine Korngrenze die Migration der Metallatome behindert. Außerdem sind dünne Leitbahnen durch die sie umgebenden Dielektrika mechanisch gut stabilisiert. Sehr breite Leitbahnen wiederum geben dem Stromfluss im Falle einer lokalen Degradation ausreichend Ausweichmöglichkeiten auf parallele Pfade.

Insofern gibt es eine mittlere Breite typischerweise in der Nähe der mittleren Korngröße, z.B. 1-3 µm, die sich als besonders kritisch für den Fehlermechanismus Elektromigration darstellt. Dieser Effekt wird in integrierten Teststrukturen bislang nicht betrachtet.

Die bekannten in-situ ausgemessenen Elektronenmigrationsstrukturen prüfen nur eine Layoutvariante ab und vergleichen deren Widerstand zu einem nicht gestressten Referenzelement oder Initialwert.

Zwar ist es denkbar, die in der Schrift US 8890556 B2 erwähnten Strukturen mehrfach mit abgeänderten Metallisierungsvarianten zu integrieren, der Platzbedarf wäre allerdings unvorteilhaft.

Die Aufgabe der Erfindung ist es die Degradation der Metallisierung der Halbleiterschaltung zu ermitteln.

### Offenbarung der Erfindung

Die erfindungsgemäße Anordnung von Leitbahnen zur Fehlerbestimmung einer Halbleiterschaltung umfasst Leitbahnen, die vorzugsweise auf einer Ebene der Halbleiterschaltung angeordnet sind. Unter dem Begriff Leitbahn wird eine Leiterbahn bzw. eine Leitungsbahn verstanden, d. h. eine elektrisch leitende Verbindung. Dabei weist die Anordnung mehrere Abschnitte auf. Diese Abschnitte sind als Reihenschaltung angeordnet. Jeder Abschnitt weist eine Anzahl von Leitbahnen auf. Die Anzahl der Leitbahnen ist in den einzelnen Abschnitten unterschiedlich. Jeder Abschnitt weist einen Anfangsbereich und einen Endbereich auf, wobei ein Spannungsdifferenzwert zwischen dem Anfangsbereich und dem Endbereich des jeweiligen Abschnitts erfassbar ist. Ist der jeweilige Abschnitt mit einem anderen bzw. vorhergehenden Abschnitt verbunden, so repräsentiert der Endbereich des vorhergehenden Abschnitts zugleich den Anfangsbereich des aktuellen bzw. jeweiligen Abschnitts. Im Fehlerfall sind die Spannungsdifferenzwerte der jeweiligen Abschnitte unterschiedlich.

Der Vorteil ist hierbei, dass eine Degradation durch Elektromigration während des Betriebs der Halbleiterschaltung auf einfache Weise erfassbar ist und bereits vor Auftreten eines Fehlers in der Halbleiterschaltung erkannt werden kann. Des Weiteren ist es vorteilhaft, dass eine separate Referenzstruktur neben der Teststruktur nicht notwendig ist, denn breite Leitbahnen degradieren entscheidend langsamer als Leitbahnen mit einer kritischen Weite bzw. Breite, der sogenannten "worst-case" Breite. Somit kann die Weite der Leitbahn des Abschnitts als Referenz dienen, der nur eine Leitbahn aufweist. Somit ist auch die Speicherung eines Initialwerts nicht zwingend notwendig.

Weiter sind die Leitbahnen eines Abschnitts gleich lang, weisen dieselbe Weite auf und sind parallel zueinander angeordnet.

Vorteilhaft ist hierbei, dass die Stromdichte im Ausgangszustand bzw. zu Beginn der Messung abschnittsweise konstant ist. Da die Stromdichte stark in die Elektromigrationsdegradation eingeht, können auf diese Weise die Degradationen der einzelnen Abschnitte einfach miteinander verglichen werden. Weiterhin ist vorteilhaft, dass durch die verschiedenen Leitbahnbreiten die Leitbahnbreite ermittelbar ist, die die höchste Degradation zeigt, und die aktuell vorliegende Degradation quantifizierbar ist. In einer Ausgestaltung sind die Weiten der Leitbahnen wenigstens in aneinanderangrenzenden Abschnitten unterschiedlich.

Vorteilhaft ist hierbei, dass verschiedene Fehlermechanismen erfassbar sind.

In einer Weiterbildung weist die schmalste Leitbahn der Anordnung eine Weite auf, die sich aus einem Quotient der breitesten Leitbahn der Anordnung und der Anzahl der Abschnitte ergibt.

Vorteilhaft ist hierbei, dass im Normalbetrieb, d. h. wenn keine Fehler vorliegen, in jedem Endbereich der Abschnitte der gleiche Spannungsdifferenzwert anliegt bzw. abfällt. Mit anderen Worten ist durch die Parallelschaltung der Leitbahnen zumindest anfänglich, d. h. ohne Degradation, der Widerstand der einzelnen Abschnitte bzw. Sektoren in etwa identisch. Ein eingeprägter Strom führt somit zu sehr ähnlichen Spannungsabfällen bzw. Spannungswerten, was die Auswertung der Spannungsdifferenzwerte entscheidend vereinfacht. Außerdem ist es vorteilhaft, dass die Anordnung der Leitbahnen, d. h. der Detektor bzw. die Teststruktur mehrere Sektoren unterschiedlicher Leitbahnbreite umfasst, da auf diese Weise Technologieschwankungen der Korngröße bzw. eine Änderung der kritischsten Leitbahnbreite zum Beispiel durch Einflüsse des Fertigungsprozesses erfasst werden.

In einer Weiterbildung weist jede Leitbahn im Endbereich des Abschnitts mindestens eine Via auf. Mit anderen Worten es können mehrere Vias im Endbereich des Abschnitts vorhanden sein. Die mindestens eine Via verbindet die Leitbahn mit einer weiteren Ebene der Halbleiterschaltung elektrisch. Die Via ist dabei senkrecht zwischen der Leitbahn und der weiteren Ebene angeordnet, sodass der Spannungswert jeder Leitbahn in der weiteren Ebene abgreifbar im Sinne von erfassbar ist. Die Vias sind auf bzw. in der weiteren Ebene der Halbleiterschaltung mittels eines Metallbereichs elektrisch verbunden, wobei der Metallbereich einen Spannungsabgriff repräsentiert.

Der Vorteil ist hierbei, dass die Spannungswerte auch auf anderen Ebenen der Halbleiterschaltung erfassbar sind, sodass beispielsweise die Auswertung auf einer einzigen Ebene erfolgen kann, die unter Umständen leichter zugänglich ist als die Ebene, auf der sich die Messstruktur bzw. der Detektor bzw. die Teststruktur, d. h. die Anordnung der Leitbahnen, befindet.

Die Vorrichtung zur Fehlerbestimmung einer Halbleiterschaltung mit einer Anordnung von Widerständen umfasst eine Anzahl von Differenzverstärkern, eine Anzahl von Komparatoren und eine Steuereinheit. Erfindungsgemäß sind die Widerstände in Form von Leitbahnen angeordnet. Die Anzahl der Differenzverstärker entspricht der Anzahl der Abschnitte. Jeder Differenzverstärker erzeugt dabei einen Spannungsdifferenzwert, wobei jeder Spannungsdifferenzwert jeweils einem der Komparatoren als erster Eingangswert zugeordnet ist. Ein Referenzwert dient den Komparatoren als zweiter Eingangswert. Die Steuereinheit erfasst Ausgangswerte der Komparatoren und erzeugt in Abhängigkeit der Ausgangswerte ein Ausgangssignal, das die Art des Fehlers repräsentiert.

Der Vorteil ist hierbei, dass eine Änderung des Widerstands durch Elektromigration, aber auch durch andere Alterungseffekte wie zum Beispiel Stressmigration zu einem abweichenden Spannungsabfall an dem entsprechenden Abschnitt bzw. Sektor führt, und damit zu einem einfach messbaren Signal.

Das erfindungsgemäße Verfahren zur Fehlerbestimmung einer Halbleiterschaltung mittels einer Anordnung von Leitbahnen umfasst die Schritte Bestimmen von Spannungsdifferenzwerten eines jeden Abschnitts der Anordnung von Leitbahnen, Erfassen eines Referenzwerts, Erzeugen eines Ausgangssignals in Abhängigkeit der Spannungsdifferenzwerte und des Referenzwerts und Bestimmen des Fehlers in Abhängigkeit des Ausgangssignals.

Vorteilhaft ist hierbei, dass das Verfahren die Degradation der Leitbahn bzw. der Metallisierung während des Betriebs der Halbleiterschaltung messen kann. Die bislang unbekannten Größen wie Einsatztemperatur, Nutzerverhalten und Materialeigenschaften werden dadurch exakt erfasst und müssen nicht geschätzt werden.

Weitere Vorteile ergeben sich aus der nachfolgenden Beschreibung von Ausführungsbeispielen bzw. aus den abhängigen Patentansprüchen.

### Kurze Beschreibung der Zeichnungen

Die vorliegende Erfindung wird nachfolgend anhand bevorzugter Ausführungsformen und beigefügter Zeichnungen erläutert. Es zeigen:
- Figur 1: eine Anordnung von Leitbahnen zur Fehlerbestimmung einer Halbleiterschaltung,
- Figur 2: ein Ersatzschaltbild einer Vorrichtung zur Fehlerbestimmung der Halbleiterschaltung und
- Figur 3: ein Verfahren zur Fehlerbestimmung der Halbleiterschaltung.

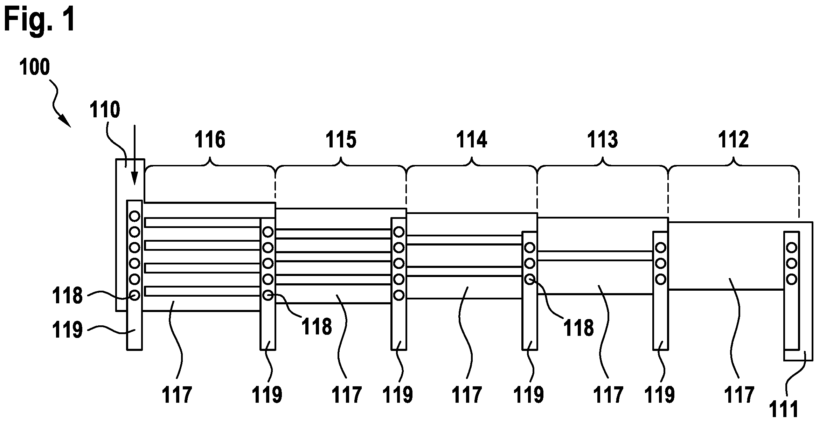

Figur 1 zeigt eine Anordnung 100 von Leitbahnen 117 zur Fehlerbestimmung einer Halbleiterschaltung. Die Anordnung 100 weist beispielhaft fünf Abschnitte 112, 113, 114, 115, 116 auf, die auf einer horizontalen Ebene des Halbleitersubstrats angeordnet sind. Die Abschnitte 112, 113, 114, 115, 116 sind in Reihe geschaltet. Dabei weist jeder Abschnitt 112, 113, 114, 115, 116 eine bestimmte Anzahl von Leitbahnen 117 auf. Ein Abschnitt 112, 113, 114, 115, 116 umfasst mindestens eine Leitbahn 117. Weist ein Abschnitt 112, 113, 114, 115, 116 mehr als eine Leitbahn 117 auf, so sind die Leitbahnen 117 in diesem Abschnitt 112, 113, 114, 115, 116 parallel zueinander angeordnet. Die Anordnung 100 weist eine erste Zuleitung 110 und eine zweite Zuleitung 111 auf. Die erste Zuleitung 110 ist mit dem Abschnitt 116 der Anordnung 100 elektrisch verbunden, der die größte Anzahl an Leitbahnen 117 umfasst. Die zweite Zuleitung 111 ist mit dem Abschnitt 112 der Anordnung 100 elektrisch verbunden, der eine einzige Leitbahn 117 aufweist.

An die erste Zuleitung 110 kann ein erstes Spannungspotential und an die zweite Zuleitung 111 ein zweites Spannungspotential angelegt bzw. angeschlossen werden. Das erste Spannungspotential ist dabei vom zweiten Spannungspotential unterschiedlich. Optional kann das zweite Spannungspotential auf Masse liegen.

Die Leitbahnen 117 in einem Abschnitt 112, 113, 114, 115, 116 bzw. innerhalb eines Abschnitts 112, 113, 114, 115, 116 weisen jeweils dieselbe Weite auf. Mit anderen Worten in einem Abschnitt bzw. Sektor haben alle Metallbahnen die gleiche Weite, wobei die Summe der Weiten für jeden Sektor in etwa identisch ist. Da die Weite der Leitbahn den Widerstand der Leitbahn beeinflusst, können gegebenenfalls leichte Korrekturen an der Weite mit dem Ziel den Randanteil des Widerstandwerts zu kompensieren notwendig sein. Außerdem werden dadurch möglichst identische Widerstandswerte pro Sektor gewährleistet. Wird die Anordnung der Leitbahnen, hier auch Detektor genannt, im Anwendungsfall mit Strom beaufschlagt, ergeben sich entsprechend der Widerstände sehr ähnliche Spannungsabfälle, Unterschied <<5%.

Als typische Materialien der Leitbahnen werden Al, Cu, W, Co, Ta, TaN, Ti, TiN bzw. Schichtkombinationen derselben verwendet. Auch hochdotierte bzw. silizidierte Polybahnen wie TiSi und CoSi mit Schichtwiderständen kleiner 50 Ohm/square werden als metallische Verbindungen genutzt. Die Schichtdicke dieser Metalle liegt typischerweise im Bereich von 100 nm bis 10 µm.

Im Endbereich weist jeder Abschnitt 112, 113, 114, 115, 116 einen Metallbereich 119 auf, der als Spannungsabgriff fungiert. Dabei ist der Endbereich des vorhergehenden Abschnitts gleichzeitig der Anfangsbereich des folgenden Abschnitts. Der Abschnitt 116, der die meisten parallel angeordneten Leitbahnen aufweist, weist auch im Anfangsbereich des Abschnitts 116 einen Metallbereich 119 auf, der als Spannungsabgriff fungiert.

In einem Ausführungsbeispiel ergibt sich die Weite der schmalsten Leitbahn 117 aus dem Quotienten der breitesten Leitbahn 117 und der Anzahl der Abschnitte 112, 113, 114, 115, 116. Die Weite der schmalsten Leitbahn repräsentiert dabei auch die "worst - case" Dimension der Leitbahn. Die minimale Strukturbreite der Metalle bzw. Leitbahnen 117 liegt je nach Technologieknoten und Metallebene im Bereich kleiner 2 µm.

In einem weiteren Ausführungsbeispiel ist die Weite der schmalsten Leitbahn 117 über die minimale Strukturbreite der Technologie definiert und liegt je nach Technologieknoten und Metallebene im Bereich kleiner 2 µm. Die Anzahl der Leitbahnen in einem Abschnitt 112, 113, 114, 115, 116 ergibt sich dabei aus dem Quotienten der breitesten Leitbahn 117 und der Leitbahnbreite im jeweiligen Abschnitt 112, 113, 114, 115, 116. Die Weite der "worst-case" Dimension der Leitbahnen 117 liegt typischerweise höher als die minimale Leitbahndimension, je nach Technologieknoten und Metallebene im Bereich zwischen 2 und 8 µm. Das bedeutet die Anordnung 100 weist mindestens eine Leitbahn im Bereich der minimalen Leitbahnbreite und eine Leitbahn im Bereich der Leitbahnbreite >=10µm auf. Bei acht Abschnitten werden beispielsweise folgende Werte der Leitbahnen in den einzelnen Abschnitten verwendet: 0.21 µm, 0.28 µm, 0.35 µm, 0.5 µm, 1.0 µm, 2.0 µm, 4.0 µm, 10.0 µm.

In einem weiteren Ausführungsbeispiel umfasst die Anordnung der Leitbahnen 117 bzw. der Detektor eine Anzahl von N Abschnitten bzw. Sektoren auf, wobei jeder Sektor i mit (1<=i<=N), "N-i+1" parallel geschaltete Metallwiderstände mit einer Weite von "W=N/(N-i+1)" aufweist.

In einem weiteren Ausführungsbeispiel weist die Anordnung 100 Zwischenmetallverbindungen sogenannte Vias 118 auf. Die Vias 118 fungieren dabei als elektrische Verbindungen zwischen verschiedenen, insbesondere vertikal angeordneten, Metallebenen der Halbleiterschaltung. Die Vias 118 sind dabei auf der Anordnung 100 im Endbereich der Abschnitte 112, 113, 114, 115, 116 angeordnet, wobei jede Leitbahn 117 mindestens eine Via 118 aufweist. Dabei weist jede Via 118 im Wesentlichen die Form eines Zylinders auf. Die Vias 118 sind im Wesentlichen senkrecht zu den Leitbahnen 117 angeordnet und mit diesen elektrisch verbunden. Zusätzlich sind Vias 118 im Anfangsbereich des Abschnitts 116 angeordnet, der die meisten Leitbahnen 117 aufweist. Die Vias 118 ermöglichen eine elektrische Verbindung der Leitbahnen 117 zu einer weiteren bzw. anderen Ebene der Halbleiterschaltung auf der sie beispielsweise leichter für die weitere Verarbeitung zugänglich sind. Die Vias 118 eines Abschnitts 112, 113, 114, 115, 116 sind mit Hilfe eines Metallbereichs 119 auf der weiteren Ebene elektrisch miteinander verbunden. Diese Metallbereiche 119 fungieren dabei als Spannungsabgriff.

In einem weiteren Ausführungsbeispiel befindet sich die weitere Ebene unterhalb der Anordnung 100 innerhalb des Halbleitersubstrats, sodass die Vias 118 unterhalb der Leitbahnen 117 angeordnet sind und die Vias 118 die Leitbahnen 117 von unten elektrisch kontaktieren.

Mit anderen Worten es befinden sich in einer Halbleiterschaltung bzw. auf einem ASIC oder einer integrierten Schaltung eine Vielzahl von Bauelementen und Schaltungsblöcken, die durch Kontakte mit einer darüberliegende Metallisierung mittels Zwischenmetallverbindungen verbunden sind. Insgesamt existieren mehrere, bis zu zehn, Metallisierungsebenen, die untereinander mittels Vias 118 elektrisch verbunden werden können. Auf einem ASIC können somit ein oder mehrere Metalldegradationsdetektoren platziert werden. Unter den Metalldegradationsdetektoren wird hierbei die erfindungsgemäße Anordnung der Leitbahnen verstanden. Typischerweise würde man für jede genutzte Metallisierungsebene einen gesonderten Detektor integrieren. Am Ende jedes Sektors wird ein Spannungsabgriff für den Sektor eingefügt, beispielsweise in derselben Metallebene, in welcher der Detektor integriert ist.

In einem weiteren Ausführungsbeispiel ist eine Kontaktierung durch darüber bzw. darunter liegende Metallebenen mittels Zwischenmetallverbindungen, den Vias, vorgesehen. Alternativ kann eine direkte Verbindung der Spannungsabgriffe zu einem unter dem Detektor liegenden Halbleiter hergestellt werden. Dies ist vorteilhaft, wenn sich die Anordnung der Leitbahnen bzw. der Detektor in der ersten Metallebene befinden, denn auf diese Weise kann der Detektor platzsparend angeordnet werden.

Es sei noch angemerkt, dass die Anordnung der Leitbahnen nicht auf fünf Abschnitte beschränkt ist. Die Anordnung der Leitbahnen kann eine beliebige Anzahl von Abschnitten bzw. Sektoren aufweisen.

In einem weiteren Ausführungsbeispiel sind Anordnungen von Leitbahnen bzw. Detektoren mit einer unterschiedlichen Anzahl von Abschnitten auf unterschiedlichen Metallebenen der Halbleiterschaltung angeordnet. Mit anderen Worten es werden ähnliche Detektoren für verschiedene Metalllagen übereinander platziert.

In einem weiteren Ausführungsbeispiel wird ein PN-Übergangs im unterliegenden Halbleiter eingebracht. Dabei kann dessen Flussspannung zur präzisen Temperaturüberwachung genutzt werden. Somit kann die Temperatur der Leitbahnen bestimmt werden. Mit der zusätzlichen Information des Spannungsabfalls an den Leitbahnen, kann man auf einen Widerstandswert bei der Vormesstemperatur zurückschließen. Somit kann der Widerstandswert bei der Vormesstemperatur bestimmt werden und als Referenzwert gespeichert werden.

In einem weiteren Ausführungsbeispiel werden weitere Leitbahnen zwischen bzw. neben den einzelnen Metallwiderständen eingebracht, die nicht in direkter metallischer Verbindung zu dem eigentlichen Detektor stehen. Diese weiteren Leitbahnen bilden ein gemeinsames elektrisches Netz, welches an eine im ASIC integrierte Auswertungsschaltung angeschlossen wird. Dadurch ist die Schaltung in der Lage, einen Kurzschluss des Netzes zum Detektor zu erfassen, z.B. durch Potentialüberwachung dieses Netzes, welches typischerweise auf Masse liegen würde, aber im Falle eines Kurzschlusses das Potential des Detektors annimmt. In den Qualifikationsstandards bzw. der konventionellen Erprobung sind solche Netze bekannt als "Extrusion-Monitors". Werden die an den Detektor angeschlossenen Leitbahnen an mindestens zwei Punkten elektrisch angeschlossen, kann deren Widerstand erfasst werden, und daraus z.B. auf die Temperatur zurückgeschlossen werden, beispielsweise gemäß der empirischen Formel R(T)=R_{25°C}*(1+(T-25°)*TCR₁+(T-25°)²*TCR₂) mit TCR_{1/2} als Temperaturkoeffizienten, T der Leitbahntemperatur und R_{25°C} dem Widerstand bei der Referenztemperatur 25°C. TCR1 ist typischerweise die Proportionalitätskonstante des linearen Anteils und TCR2 des quadratischen Anteils.

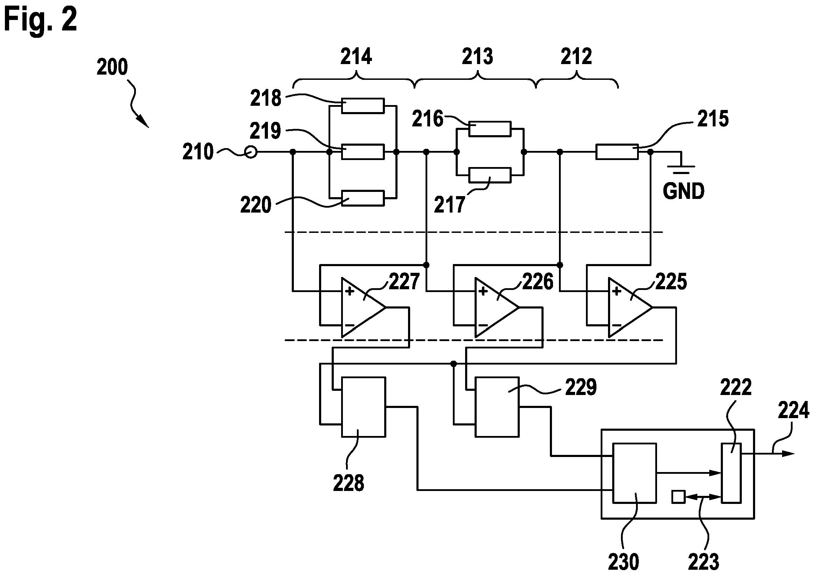

Figur 2 zeigt ein Ersatzschaltbild einer Vorrichtung 200 zur Fehlerbestimmung einer Halbleiterschaltung. Die Vorrichtung 200 weist beispielhaft drei Abschnitte 212, 213, 214 auf, die in Reihe geschaltet sind. Mit anderen Worten die Vorrichtung umfasst seriell geschaltete Sektoren von Metallwiderständen. Jeder Abschnitt 212, 213, 214 weist dabei eine bestimmte Anzahl von Widerständen 215, 216, 217, 218, 219, 220 auf. Die Widerstände sind in den jeweiligen bzw. einzelnen Abschnitten parallel zueinander angeordnet. Die Vorrichtung 200 weist eine erste Zuleitung 210 auf, die an den Abschnitt 214 angeschlossen ist, der die meisten parallel geschalteten Widerstände 218, 219, 220 aufweist. Die Vorrichtung 200 weist eine zweite Zuleitung 211 auf, die an den Abschnitt 212 angeschlossen ist, der einen einzigen Widerstand 215 aufweist. Die Vorrichtung 200 weist eine Anzahl von Differenzverstärkern 225, 226, 227 auf, die der Anzahl der Abschnitte 212, 213, 214 entspricht. Die erste Zuleitung 210 ist mit einem ersten Spannungspotential verbindbar bzw. verbunden und die zweite Zuleitung 211 mit einem zweiten Spannungspotential. Das zweite Spannungspotential ist meistens die elektrische Masse. Der positive Eingang eines jeden Differenzverstärkers 225, 226, 227 ist mit dem Ausgang des in Reihe vorhergehend geschaltenen Abschnitts verbunden. Handelt es sich um den Differenzverstärkers 227, der dem Abschnitt 214 mit den meisten parallel angeordneten Leitbahnen zugeordnet ist, so ist der positive Eingang des Differenzverstärkers 227 mit der ersten Zuleitung 210 elektrisch verbunden. Der negative Eingang eines jeden Differenzverstärkers ist mit dem Ausgang des Abschnitts 214 verbunden. Handelt es sich um den Differenzverstärker 225, der dem Abschnitt 212 zugeordnet ist, d. h. der Abschnitt der einen einzigen Widerstand 215 aufweist, so ist der negative Eingang des Differenzverstärkers auf Masse gelegt. Die Vorrichtung 200 umfasst Komparatoren 228 und 229, die mit den Ausgängen der Differenzverstärker elektrisch leitend verbunden sind. Die Vorrichtung 200 umfasst eine Steuereinheit 221 mit einem ODER-Gatter 230, einem Mikrocontroller 222 und einem Speicher 223. Die Steuereinheit 221 ist eingangsseitig mit den Ausgängen der Komparatoren 228 und 229 elektrisch verbunden, d. h. die Steuereinheit 221 erfasst die Ausgangssignale der Komparatoren 228 und 229. Die Steuereinheit 221 erzeugt in Abhängigkeit der Ausgangssignale der Komparatoren 228 und 229 mit Hilfe des ODER-Gatters 230 und des Mikrocontrollers 222 ein Signal 224, d. h. das Detektorsignal, das die Art des Fehlers anzeigt. Das bedeutet, der Fehlermechanismus der Halbleiterschaltung kann aus dem Signal 224, auch Detektorsignal genannt, abgeleitet werden. Dabei wird zwischen den Fehlermechanismen der Elektromigration, der Stressmigration und der Unterätzung von Leitbahnen unterschieden.

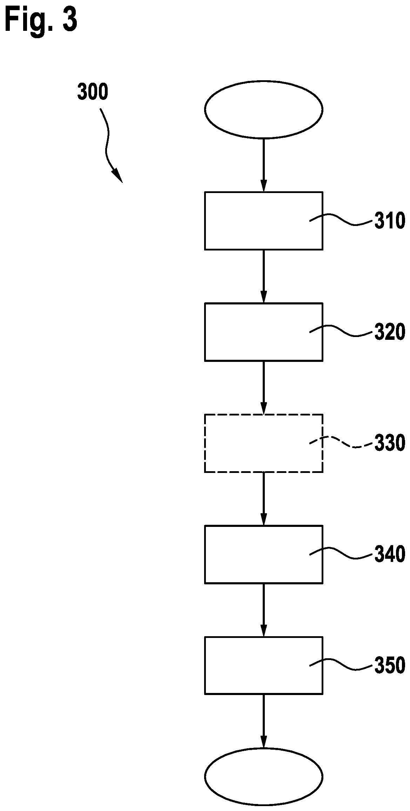

Figur 3 zeigt das Verfahren zur Fehlerbestimmung einer Halbleiterschaltung. Das Verfahren startet mit Schritt 310, in dem jeder Differenzspannungsverstärker einen ersten Spannungswert in einem Anfangsbereich des jeweiligen Abschnitts als ersten Eingangswert erfasst und einen zweiten Spannungswert im Endbereich des jeweiligen Abschnitts als zweiten Eingangswert erfasst, um daraus einen Spannungsdifferenzwert zu ermitteln und ggf. zu verstärken. Zur Erfassung der Spannungsdifferenzwerte wird ein Messstrom in die Anordnung der Leitbahnen eingeprägt, d. h. es fliesst ein Strom in der Anordnung der Leitbahnen. Mit anderen Worten es fließt ein Strom über den Detektor. Dadurch kann der Spannungsabfall über den einzelnen Sektoren mit entsprechenden Differenzverstärkern erfasst werden. Da die Widerstandswerte der Abschnitte einen ähnlichen bzw. identischen Widerstandswert aufweisen, ergeben sich bei seriellen Stromfluss durch die Abschnitte zumindest bei Beginn der Messung ähnliche bzw. identische Differenzspannungen. Ähnliche bzw. identische Differenzspannungen bedeuten, dass kein Fehler vorhanden ist. In einem folgenden Schritt 320 wird ein Referenzwert erfasst. Dabei wird üblicherweise der Spannungsdifferenzwert eines nicht degradierenden Abschnitts der Widerstandsanordnung als Referenzwert erfasst. Vorzugsweise wird hierbei der Abschnitt mit der breitesten Leitbahn zur Ermittlung des Referenzwerts verwendet. Alternativ kann auch der Spannungsdifferenzwert als Referenzwert verwendet werden, der über einer Leitbahn abfällt, die physikalische Löcher im Metall aufweist, sodass der Materialtransport gehemmt ist. Dadurch kann ein stabiler Referenzwert erzeugt werden. In einem optionalen Schritt 330 werden weitere Spannungsdifferenzwerte erfasst. Dabei werden für jeden Abschnitt der Anordnung der Leitbahnen der zugehörige Spannungsdifferenzwert, der über dem jeweiligen Abschnitt abfällt, erfasst. Mittels Komparatoren, insbesondere Fensterkomparatoren, werden die einzelnen Spannungsdifferenzwerte zu dem Referenzspannungswert verglichen. In einem folgenden Schritt 340 erfasst die Steuereinheit die Ausgangswerte der einzelnen Komparatoren. Die Ausgangswerte werden mittels ODER-Gatter verglichen und es wird in Abhängigkeit der Ausgangswerte ein Ausgangsignal erzeugt, das anzeigt, ob der Spannungsdifferenzwert eines der Abschnitte gegenüber dem Spannungsdifferenzwert des nicht degradierenden Abschnitts eine einstellbare Toleranzschwelle überschritten hat. In einem folgenden Schritt 350 wird in Abhängigkeit des Ausgangssignals ein Fehler bestimmt. Mit anderen Worten aus dem Detektorsignal kann der Fehlermechanismus abgeleitet werden. Dazu wird das Ausgangssignal des ODER-Gatters der Steuereinheit 221 zugeführt, die eine analoge Auswerteschaltung oder einen Mikrocontroller 222 als digitale Auswerteschaltung aufweist.

In einer Weiterbildung kann die Steuereinheit 221 auch derart ausgelegt sein, dass die Signale aller Fensterkomparatoren für die einzelnen Abschnitte gemäß komplexeren Logiken bewertet werden, zum Beispiel als Verknüpfung der Signale gemäß ihrer Leitbahndimensionen. So kann eine starke Änderung von Abschnitten mit Leitbahnen mittlerer Breite ein Indiz für Elektromigration sein, während die Degradation besonders schmaler Leitbahnen auf eine Unterätzung während der Prozessierung oder Stressmigration hinweist.

In einer Weiterbildung weist die Steuereinheit einen nichtflüchtigen Speicher 223 auf, sodass Spannungsdifferenzwerte zu verschiedenen Zeitpunkten gespeichert werden können, beispielsweise die Spannungsdifferenzwerte bei einer Initialmessung.

Beim Fehlermechnismus der Elektromigration weist vor allem der Abschnitt mit Leitbahnen eine Widerstandsänderung auf, die eine mittlere Breite aufweisen, d. h. der Spannungsabfall bzw. die Spannungsdifferenz ist wesentlich höher als die Spannungsdifferenz des Abschnitts der die breiteste Leitbahn aufweist. Der Abschnitt, der die breiteste Leitbahn aufweist kann bzw. dient als Referenzspannung.

Beim Fehlermechanismus Stressmigration wird die Spannungsdifferenz in den Abschnitten mit der minimalen Breite bzw. Weite der Leitbahnen höher sein als die Referenzspannungsdifferenz.

Der Fehlermechanismus der Unterätzung der Leitbahnen hat typischerweise besonders starken Einfluss auf die Strukturen mit minimaler Breite, ist aber schon im Fertigungsprozess angelegt und kann je nach Ausprägung bereits bei einer Initialmessung erkannt werden.

In einem Ausführungsbeispiel wird als Detektorsignal die maximale Spannungsdifferenz zwischen den einzelnen Abschnitten erfasst, wobei die maximale Spannungsdifferenz ein Maß für die höchste Widerstandsänderung bzw. Widerstandsabweichung der Abschnitte ist.

Alternativ wird insbesondere bei digitaler Prozessierung der Spannungswerte als Detektorsignal der am stärksten degradierende Sektor ermittelt und ausgeben.

In einem weiteren Ausführungsbeispiel wird das Detektorsignal über die aktuelle Temperatur des Detektors auf eine standardisierte Temperatur- und Messbedingung zurückgerechnet. Die Temperatur des Detektors kann wie oben beschrieben mit Hilfe der temperaturabhängigen Widerstandsformel aus anderen Metallwiderständen oder über integrierte Temperaturdioden ermittelt werden. Der ermittelte Spannungsabfall kann folglich gegen einen im nichtflüchtigen Speicher 223 abgelegten Vergleichswert verglichen werden, sodass die absolute Degradation der Halbleiterschaltung seit Fertigungsdatum bestimmt werden kann. Der gespeicherte Vergleichswert wird beispielsweise mittels der Prüfung auf Funktionalität der Halbleiterschaltung typischerweise bei der Endkontrolle oder beim Vormessen des ASICs erfasst. Somit wird ein Initial- bzw. Vergleichswert oder Referenzwert in dem nichtflüchtigen Speicher abgelegt.

Der Initialwert des Abschnitts mit minimaler Leitbahnbreite stellt eine interessante Größe dar. Er korreliert stark mit der Metallbreite der minimalen Leitbahnen. Diese Metallbreite geht ein in minimale Metallwiderstände, wie sie in Analogschaltung eingesetzt werden.

Die Information über diese Leitbahnbreite kann bei der Funktionsüberprüfung verwendet werden, um entsprechende Analogschaltungen zu kalibrieren. Des Weiteren ist die exakte Bestimmung des Metallwiderstands für das Timing von integrierten Logiken limitierend, denn werden die Leitbahnen zu schmal, steigt der Widerstand an, und Signallaufzeiten erhöhen sich bis zu dem Punkt, dass die Logik des ASICs nicht mehr funktioniert. Die Kenntnis über diese Leitbahnbreite gibt also die Möglichkeit, den maximalen erlaubten Takt der Schaltung zu reduzieren, oder andere Maßnahmen zu ergreifen, um den spezifizierten Takt doch zu erreichen, z.B. Erhöhung der internen Versorgungsspannung.

Während des Betriebs der Halbleiterschaltung wird ein typischer Strom durch den Detektor geleitet. Dieser kann ein Gleichstrom sein, der z.B. den nominal zulässigen Strom der Gesamtweite wiedergibt oder der absichtlich höher gelegt wird, um ein Auslösen des Detektors vor dem Auftreten funktionaler Probleme im ASIC sicherzustellen. Alternativ wird ein gepulster Strom eingeprägt, falls das die Verhältnisse in der Schaltung präziser abbildet. Der Strom kann aus einem speziellen Schaltungsblock, z.B. DC-DC Konverter erzeugt werden, um die Verlustleistung des Detektors im Betrieb zu minimieren. Die Ermittlung des Detektorsignals erfolgt entweder permanent, mit entsprechenden Filterungen, z.B. Mittelwertbildung, und Plausibilisierungen, um sicherzustellen, dass nur sinnvoll gemessene Detektorsignale zur Evaluierung benutzt werden. Hierzu wird beispielsweise bei der Auswertung des Detektors und vor der Auslösung eines Fehlersignals geprüft, ob beim Meßvorgang tatsächlich ein ausreichender Strom durch den Detektor anlag.

Die Auswertung des Detektors bzw. die Auswertung der Anordnung der Leitbahnen kann zu verschiedenen Zeitpunkten erfolgen. Initial beim Wafertest, auch um die Funktion der Struktur zu überprüfen und einen Initialwert als Referenzwert zu speichern. Nach dem Verpackungsprozess im finalen Testschritt, um den Einfluss des Verpackungsprozesses zu überprüfen. Im Feld, d. h. Betrieb der Halbleiterschaltung, bei jeder Startprozedur oder für sicherheitskritische Anwendungen auch permanent während des Betriebs.

Es sind verschiedene Reaktionen eines übergeordneten ASIC-Systems, in das die Halbleiterschaltung eingebettet ist, auf das Detektorsignal möglich. Es wird beispielsweise ein Vergleich zu einer maximalen Spezifikation, z.B. maximale Abweichung der einzelnen Sektoren von 20% durchgeführt.

Die maximale Spezifikation dient dabei als einstellbare Toleranzschwelle bzw. Schwellenwert. Falls dieser überschritten ist, erfolgt eine Meldung an das ASIC-System oder den übergeordneten Controller. Alternativ erfolgt eine generelle Übermittlung des Detektorsignals an das ASIC-System oder den übergeordneten Controller, welcher auf Grundlage der Daten des Degradationsmonitors, gegebenenfalls in Kombination mit anderen Degradationsdetektoren, das ASIC-System nachkalibrieren und zumindest limitiert funktionsfähig halten kann.

## Patentansprüche

1. Anordnung (100) von Leitbahnen (117) zur Fehlerbestimmung einer Halbleiterschaltung, wobei die Leitbahnen (117) vorzugsweise auf einer Ebene der Halbleiterschaltung angeordnet sind, wobei
• die Anordnung (100) mehrere Abschnitte (112, 113, 114, 115, 116) aufweist, wobei die Abschnitte (112, 113, 114, 115, 116) als Reihenschaltung angeordnet sind, wobei
• jeder Abschnitt (112, 113, 114, 115, 116) eine Anzahl von Leitbahnen (117) aufweist, wobei
• die Anzahl der Leitbahnen (117) in den jeweiligen Abschnitten (112, 113, 114, 115, 116) unterschiedlich ist, wobei
• jeder Abschnitt (112, 113, 114, 115, 116) einen Anfangsbereich und einen Endbereich aufweist, wobei ein Spannungsdifferenzwert zwischen dem Anfangsbereich und dem Endbereich des jeweiligen Abschnitts (112, 113, 114, 115, 116) erfassbar ist, und die Spannungsdifferenzwerte der jeweiligen Abschnitte (112, 113, 114, 115, 116) im Fehlerfall unterschiedlich sind,
• wobei die Leitbahnen (117) eines jeden Abschnitts (112, 113, 114, 115, 116) gleich lang sind, dieselbe Weite aufweisen und parallel zueinander angeordnet sind.

2. Anordnung (100) von Leitbahnen (117) nach Anspruch 1, **dadurch gekennzeichnet, dass** die Weiten der Leitbahnen (117) wenigstens in aneinanderangrenzenden Abschnitten (112, 113, 114, 115, 116) unterschiedlich sind.

3. Anordnung (100) von Leitbahnen (117) nach einem der vorhergehenden Ansprüche, **dadurch gekennzeichnet, dass** die schmalste Leitbahn (117) der Anordnung (100) eine Weite aufweist, die sich aus einem Quotient der breitesten Leitbahn (117) und der Anzahl der Abschnitte (112, 113, 114, 115, 116) ergibt.

4. Anordnung (100) von Leitbahnen (117) nach einem der vorhergehenden Ansprüche, **dadurch gekennzeichnet, dass** jede Leitbahn (117) im Endbereich des jeweiligen Abschnitts (112, 113, 114, 115, 116) mindestens eine Via (118) aufweist, wobei die Via (118) die Leitbahn (117) mit einer weiteren Ebene der Halbleiterschaltung elektrisch verbindet, vorzugsweise senkrecht, sodass der Spannungsdifferenzwert jedes Abschnitts (117) in der weiteren Ebene der Halbleiterschaltung erfassbar ist, wobei die Vias (118) auf der weiteren Ebene mit einem Metallbereich (119) elektrisch verbunden sind und der Metallbereich (119) einen Spannungsabgriff repräsentiert.

5. Vorrichtung (200) zur Fehlerbestimmung einer Halbleiterschaltung mit einer Anordnung von Widerständen (215, 216, 217, 218, 219, 220), einer Anzahl von Differenzverstärkern (225, 226, 227), einer Anzahl von Komparatoren (228, 229) und einer Steuereinheit (221), **dadurch gekennzeichnet, dass** die Widerstände (215, 216, 217, 218, 219, 220) in Form von Leitbahnen (117) nach einem der vorhergehenden Ansprüche angeordnet sind, die Anzahl der Differenzverstärker (225, 226, 227) der Anzahl der Abschnitte (212, 213, 214) entspricht, wobei jeder Differenzverstärker (225, 226, 227) einen Spannungsdifferenzwert erzeugt, wobei jeweils ein Spannungsdifferenzwert jeweils einem der Komparatoren (228, 229) als erster Eingangswert zugeordnet ist, wobei ein Referenzwert den Komparatoren (228, 229) als zweiter Eingangswert zugeordnet ist, und die Steuereinheit (221) Ausgangswerte der Komparatoren (228, 229) erfasst und in Abhängigkeit der Ausgangswerte der Komparatoren (228, 229) ein Ausgangssignal (224) erzeugt, das die Art des Fehlers repräsentiert.

6. Verfahren (300) zur Fehlerbestimmung einer Halbleiterschaltung mittels einer Anordnung von Leitbahnen nach einem der Ansprüche 1 bis 4 mit den Schritten:
• Bestimmen (310) von Spannungsdifferenzwerten eines jeden Abschnitts der Anordnung von Leitbahnen,
• Erfassen (320) eines Referenzwerts,
• Erzeugen (330) eines Ausgangssignals in Abhängigkeit der Spannungsdifferenzwerte und des Referenzwerts und
• Bestimmen (340) des Fehlers in Abhängigkeit des Ausgangssignals.

## Claims

1. Arrangement (100) of interconnects (117) for error determination for a semiconductor circuit, the interconnects (117) preferably being arranged on one plane of the semiconductor circuit, wherein
• the arrangement (100) has multiple sections (112, 113, 114, 115, 116), wherein the sections (112, 113, 114, 115, 116) being arranged as a series circuit, wherein
• each section (112, 113, 114, 115, 116) has a number of interconnects (117), wherein
• the number of interconnects (117) in the respective sections (112, 113, 114, 115, 116) is different, wherein
• each section (112, 113, 114, 115, 116) has a starting region and an end region, a voltage difference value between the starting region and the end region of the respective section (112, 113, 114, 115, 116) being detectable, and the voltage difference values of the respective sections (112, 113, 114, 115, 116) being different in the event of error,
• wherein the interconnects (117) of each section (112, 113, 114, 115, 116) are of the same length, have the same width and are arranged parallel to one another.

2. Arrangement (100) of interconnects (117) according to Claim 1, **characterized in that** the widths of the interconnects (117) are different at least in adjoining sections (112, 113, 114, 115, 116).

3. Arrangement (100) of interconnects (117) according to either of the preceding claims, **characterized in that** the narrowest interconnect (117) of the arrangement (100) has a width that is obtained from a quotient of the widest interconnect (117) and the number of sections (112, 113, 114, 115, 116) .

4. Arrangement (100) of interconnects (117) according to one of the preceding claims, **characterized in that** each interconnect (117) has at least one via (118) in the end region of the respective section (112, 113, 114, 115, 116), wherein the via (118) electrically connects the interconnect (117) to a further plane of the semiconductor circuit, preferably vertically, so that the voltage difference value of each section (117) is detectable in the further plane of the semiconductor circuit, wherein the vias (118) are electrically connected on the further plane to a metal region (119), and the metal region (119) represents a voltage tap.

5. Apparatus (200) for error determination for a semiconductor circuit having an arrangement of resistors (215, 216, 217, 218, 219, 220), a number of differential amplifiers (225, 226, 227), a number of comparators (228, 229) and a control unit (221), **characterized in that** the resistors (215, 216, 217, 218, 219, 220) are arranged in the form of interconnects (117) according to one of the preceding claims, the number of differential amplifiers (225, 226, 227) corresponds to the number of sections (212, 213, 214), wherein each differential amplifier (225, 226, 227) generates a voltage difference value, wherein a respective voltage difference value is associated with a respective one of the comparators (228, 229) as a first input value, wherein a reference value is associated with the comparators (228, 229) as a second input value, and the control unit (221) detects output values of the comparators (228, 229) and takes the output values of the comparators (228, 229) as a basis for generating an output signal (224) representing the type of error.

6. Method (300) for error determination for a semiconductor circuit by means of arrangement of interconnects according to one of Claims 1 to 4, having the steps of:
• determining (310) voltage difference values for each section of the arrangement of interconnects,
• detecting (320) a reference value,
• generating (330) an output signal on the basis of the voltage difference values and the reference values, and
• determining (340) the error on the basis of the output signal.

## Revendications

1. Agencement (100) de pistes conductrices (117) pour la détermination de défauts d'un circuit à semi-conducteurs, dans lequel les pistes conductrices (117) sont de préférence disposées sur un plan du circuit à semi-conducteurs,
• l'agencement (100) présentant plusieurs segments (112, 113, 114, 115, 116), dans lequel les segments (112, 113, 114, 115, 116) sont disposés en tant que montage en série, dans lequel
• chaque segment (112, 113, 114, 115, 116) présente un certain nombre de pistes conductrices (117), dans lequel
• le nombre de pistes conductrices (117) dans les segments (112, 113, 114, 115, 116) respectifs est différent, dans lequel
• chaque segment (112, 113, 114, 115, 116) présente une zone de début et une zone d'extrémité, dans lequel une valeur de différence de tension entre la zone de début et la zone d'extrémité du segment (112, 113, 114, 115, 116) respectif peut être détectée, et les valeurs de différence de tension des segments (112, 113, 114, 115, 116) respectifs sont différentes en cas de défaut,
• dans lequel les pistes conductrices (117) de chaque segment (112, 113, 114, 115, 116) sont de même longueur, présentent la même largeur, et sont disposées parallèlement entre elles.

2. Agencement (100) de pistes conductrices (117) selon la revendication 1, **caractérisé en ce que** les largeurs des pistes conductrices (117) sont différentes au moins dans des segments (112, 113, 114, 115, 116) adjacents les uns aux autres.

3. Agencement (100) de pistes conductrices (117) selon l'une des revendications précédentes, **caractérisé en ce que** la piste conductrice (117) la plus étroite de l'agencement (100) présente une largeur qui résulte d'un quotient de la piste conductrice (117) la plus large et du nombre de segments (112, 113, 114, 115, 116).

4. Agencement (100) de pistes conductrices (117) selon l'une des revendications précédentes, **caractérisé en ce que** chaque piste conductrice (117) présente au moins un trou d'interconnexion (118) dans la zone d'extrémité du segment (112, 113, 114, 115, 116) respectif, dans lequel le trou d'interconnexion (118) connecte électriquement la piste conductrice (117) à un autre plan du circuit à semi-conducteurs, de préférence perpendiculairement, de sorte que la valeur de différence de tension de chaque segment (117) dans l'autre plan du circuit à semi-conducteurs peut être détectée, dans lequel les trous d'interconnexion (118) sur l'autre plan sont connectés électriquement à une zone métallique (119) et la zone métallique (119) représente une prise de tension.

5. Dispositif (200) pour la détermination de défauts d'un circuit à semi-conducteurs avec un agencement de résistances (215, 216, 217, 218, 219, 220), un certain nombre d'amplificateurs différentiels (225, 226, 227), un certain nombre de comparateurs (228, 229) et une unité de commande (221), **caractérisé en ce que** les résistances (215, 216, 217, 218, 219, 220) sont disposées sous forme de pistes conductrices (117) selon l'une des revendications précédentes, le nombre d'amplificateurs différentiels (225, 226, 227) correspond au nombre de segments (212, 213, 214), dans lequel chaque amplificateur différentiel (225, 226, 227) génère une valeur de différence de tension, dans lequel respectivement une valeur de différence de tension est respectivement associée à l'un des comparateurs (228, 229) en tant que première valeur d'entrée, dans lequel une valeur de référence est associée aux comparateurs (228, 229) en tant que deuxième valeur d'entrée, et l'unité de commande (221) détecte des valeurs de sortie des comparateurs (228, 229) et génère un signal de sortie (224) en fonction des valeurs de sortie des comparateurs (228, 229), lequel signal représente le type de défaut.

6. Procédé (300) pour la détermination de défauts d'un circuit à semi-conducteurs au moyen d'un agencement de pistes conductrices selon l'une des revendications 1 à 4 avec les étapes suivantes :
la détermination (310) de valeurs de différence de tension de chaque segment de l'agencement de pistes conductrices,
la détection (320) d'une valeur de référence,
la génération (330) d'un signal de sortie en fonction des valeurs de différence de tension et de la valeur de référence, et
la détermination (340) du défaut en fonction du signal de sortie.
